# EUROPEAN PATENT APPLICATION

(11) **EP 4 404 286 A1**
(43) Date of publication of application: **24.07.2024**
(21) Application number: 22916384.5
(22) Date of filing: 04.11.2022
(51) Int. Cl.: H01L 33/48, H01L 27/15, H05K 9/00

(54) **DISPLAY MODULE HAVING ELECTROSTATIC DISCHARGE PROTECTION WIRING, AND DISPLAY DEVICE COMPRISING SAME**

(30) Priority: 28.12.2021 KR 20210190192
(71) Applicant: Samsung Electronics Co., Ltd., Suwon-si, Gyeonggi-do 16677 (KR)
(72) Inventor: KIM, Hyunjun, Suwon-si Gyeonggi-do 16677 (KR); PARK, Jihoon, Suwon-si Gyeonggi-do 16677 (KR); YEO, Yonghoon, Suwon-si Gyeonggi-do 16677 (KR); JEONG, Seulki, Suwon-si Gyeonggi-do 16677 (KR); KIM, Dooyoung, Suwon-si Gyeonggi-do 16677 (KR)
(74) Representative: Appleyard Lees IP LLP
(86) International application number: PCT/KR2022/017260
(87) International publication number: WO 2023/128230

(57) **Abstract**

Disclosed are a display module having electrostatic discharge (ESD) protection wiring and a display device comprising same. The disclosed display module may comprise: a substrate having a plurality of first electrode pads arranged on a front surface; a plurality of light-emitting diode packages in which a plurality of light-emitting diodes are mounted on the front surface and a plurality of second electrode padss electrically connected to the plurality of first electrode pads are arranged on a rear surface; and a first ESD protection wiring discontinuously arranged on the front surface of the substrate along a first side of the substrate.

## Description

### [TECHNICAL FIELD]

The disclosure relates to a display module having an electrostatic discharge (ESD) protection structure and a display device comprising the same.

### [BACKGROUND ART]

A display module includes a plurality of ESD protection devices coupled by channel and common line for each driving integrated circuit (IC) chip. The display module protects internal circuitry from ESD using the plurality of ESD protection devices. In addition, a non-conductive material is attached to a substrate of the display module and protects against ESD infiltration to the internal circuitry of the display module.

A number of ESD protection devices included in the display module may be a number corresponding to a number of pixels mounted in the display module. In this case, if a ultra-small light emitting diode such as a micro LED is mounted, securing a space for mounting the plurality of ESD protection devices in the display module may be difficult and thereby, processing time may be increased. In addition, there may be a problem of not being able to protect against ESD being introduced to fine gaps formed between a non-conductive material and a substrate attached to the display module.

### [DISCLOSURE]

### [TECHNICAL SOLUTION]

An object of the disclosure is in providing a display module which protects an internal circuitry of the display module from ESD by arranging ESD protection wiring along an upper side and a lower side of the display module and a display device including the same.

The disclosure to achieve the object above provides a display module including a substrate arrayed with a plurality of first electrode pads at a front surface of the substrate, a plurality of light emitting diode packages arrayed with a plurality of second electrode pads on which a plurality of light emitting diode are mounted at a front surface of the plurality of light emitting diode packages and electrically connected to the plurality of first electrode pads at a rear surface of the plurality of light emitting diode packages, and first electrostatic discharge (ESD) protection wiring arranged discontinuously along a first side of the substrate at the front surface of the substrate.

The front surface of the substrate may be covered with an insulation layer, and the insulation layer may be provided with a plurality of first openings which expose the plurality of first electrode pads and a plurality of second openings which expose a portion of the first ESD protection wiring.

The first ESD protection wiring may be configured such that a center part is electrically coupled to one from among the plurality of first electrode pads, and both end parts are arranged adjacently to other first electrode pads which are arranged spaced apart at both sides of the electrically connected first electrode pad, respectively.

The first ESD protection wiring may be configured such that both end parts are exposed by the plurality of second openings.

The first ESD protection wiring may be arranged more closely to the first side of the substrate than the first electrode pads arranged most closely to the first side of the substrate from among the plurality of first electrode pads.

The plurality of second openings may have a hidden line pattern.

The display module may further include second ESD protection wiring arranged discontinuously along a second side of the substrate positioned at an opposite side of the first side of the substrate.

The insulation layer may be provided with a plurality of third openings which expose both end parts of the second ESD protection wiring.

Each micro light emitting diode package may include a micro integrated circuit (micro IC) chip which controls driving of the plurality of micro light emitting diodes.

In addition, in the disclosure, the above object is achievable by providing a display module including a substrate, a plurality of micro light emitting diode packages which are grid arrayed at one surface of the substrate, and first ESD protection wiring and second ESD protection wiring which are arranged discontinuously along both sides of the substrate at one surface of the substrate.

One surface of the substrate may be covered with an insulation layer, and the insulation layer may be provided with a plurality of openings which expose a portion of the first ESD protection wiring and a portion of the second ESD protection wiring. The plurality of openings may have a hidden line pattern.

In addition, in the disclosure, the above object is achievable by providing a display device including a first substrate, a plurality of display modules grid arrayed at the first substrate, and a processor configured to control driving of the plurality of display modules, and each display module includes a second substrate, a plurality of micro light emitting diode packages grid arrayed at one surface of the second substrate, first ESD protection wiring and first ESD protection wiring arranged discontinuously along both sides of the substrate at one surface of the substrate, and an insulation layer which covers one surface of the second substrate, and has a plurality of openings which expose a portion of the first ESD protection wiring and a portion of the second ESD protection wiring.

The plurality of openings may have a hidden line pattern.

A plurality of electrode pads to which the plurality of micro light emitting diode packages are electrically connected may be provided at one surface of the second substrate, the first ESD protection wiring may be positioned between one side of the substrate and the plurality of electrode pads which are most adjacent to the one side of the substrate, and the second ESD protection wiring may be arranged between an opposite side of the substrate and the plurality of electrode pads which are most adjacent to the opposite side of the substrate.

### [DESCRIPTION OF DRAWINGS]

FIG. 1 is a block diagram of a display device according to an embodiment of the disclosure;
FIG. 2 is a diagram illustrating a display device grid arrayed with a plurality of display modules according to an embodiment of the disclosure;
FIG. 3 is a diagram illustrating an enlarged A part of the display module shown in FIG. 2;
FIG. 4 is a diagram illustrating a rear surface of a light emitting diode package;
FIG. 5 is a diagram illustrating a pattern of ESD protection wiring provided at a front surface of a display substrate;
FIG. 6 is a diagram illustrating schematically a plurality of channel lines and a plurality of common scan lines to which a plurality of pixels of a package substrate are coupled;
FIG. 7 is a diagram grid arrayed with a plurality of light emitting diode packages on a display substrate;
FIG. 8 is a diagram illustrating an enlarged B part of the substrate shown in FIG. 5; and
FIG. 9 is a diagram illustrating an enlarged C part of the substrate shown in FIG. 8.

### [DETAILED DESCRIPTION OF EXEMPLARY EMBODIMENTS]

Various embodiments will be described in greater detail below with reference to the accompanied drawings. Embodiments described herein may be variously modified. A specific embodiment may be illustrated in the drawings and described in detail in the detailed description. However, the specific embodiment described in the accompanied drawing is only to assist in the easy comprehension of the various embodiments. Accordingly, it should be noted that the technical spirit is not limited by the specific embodiments described in the accompanied drawings, and should be interpreted to include all modifications, combinations, equivalents and/or alternatives of the embodiments included in the spirit of the disclosure and in the technical scope

In the disclosure, terms including ordinal numbers such as first and second may be used in describing the various elements, but the elements are not limited by the above-described terms. The above-described terms may be used only for the purpose of distinguishing one element from another element.

In the disclosure, it is to be understood that the terms such as "include" or "have" are used herein to designate a presence of a characteristic, number, step, operation, element, component, or a combination thereof, and not to preclude a presence or a possibility of adding one or more of other characteristics, numbers, steps, operations, elements, components or a combination thereof. When a certain element is indicated as being "coupled with/to" or "connected to" another element, it may be understood as the certain element being directly coupled with/to or connected to the another element, or an element being present therebetween. On the other hand, when a certain element is indicated as "directly coupled with/to" or "directly connected to" another element, it may be understood as an element not being present therebetween.

In the disclosure, the term "module" or "part" perform at least one function or operation, and may be implemented with a hardware or software, or implemented with a combination of hardware and software. In addition, a plurality of "modules" or a plurality of "parts," except for a "module" or a "part" which needs to be implemented to a specific hardware, may be integrated in at least one module and implemented as at least one processor.

The display module may include a plurality of light emitting diode packages. The plurality of light emitting diode packages may be arrayed with a plurality of inorganic light emitting diodes (inorganic LEDs), respectively. The inorganic LED may be a micro LED having a size of less than or equal to 100*µ*m. The display module with the micro LEDs may provide better contrast, faster response time and higher energy efficiency than a liquid crystal display (LCD) panel which requires a backlight. Both an organic light-emitting diode (OLED) and a micro LED may have good energy efficiency, but the micro LED has higher brightness, superior light-emitting efficiency, and longer life span than the OLED. The micro LED may be a semiconductor chip which can diverge light on its own when power is supplied. The micro LED may have a fast response time, low power, and high brightness. Specifically, the micro LED may have higher efficiency in converting electricity to photons compared to the LCD or OLED. That is, "brightness per watt" may be higher compared to LCDs or OLED displays of the related art. Accordingly, the micro LED may produce the same brightness with about half of the energy compared to the LED (having a size that exceeds 100*µ*m) or OLED. In addition thereto, the micro LED may implement high resolution, superior colors, contrast, and brightness, accurately represent a wide range of colors, and implement a clear screen in even outdoors with bright sunlight. Further, the micro LED is resistant against a burn-in phenomenon and deformation due to low heat generation.

The micro LED may be such that anode and cathode electrode terminals are formed at a same first surface and a light emitting surface has a flip chip structure formed at a second surface positioned at an opposite side of the first surface on which the electrode terminals are formed.

The display module may be configured such that a substrate and a plurality of LED packages are transferred to a front surface of the substrate in a grid array. Each LED package may include a package substrate formed of multi-layers, a plurality of micro LEDs mounted at a front surface of the package substrate, a driving IC arranged inside of the package substrate, a micro IC for driving pixels, and a plurality of package electrode pads arrayed at a rear surface of the substrate.

A pixel driving method of the display module may be an active matrix (AM) driving method of a passive matrix (PM) driving method. The display module may form wiring patterns to which respective micro LEDs are electrically connected according to the AM driving method or the PM driving method. In one pixel area, a plurality of pulse amplitude modulation (PAM) control circuits may be arranged. In this case, each sub pixel arranged in the one pixel area may be controlled by the corresponding PAM control circuit. In addition, in one pixel area, a plurality of pulse width modulation (PWM) control circuits may be arranged. In this case, each sub pixel arranged in the one pixel area may be controlled by the corresponding PWM control circuit.

The display module may be installed and applied in a wearable device, a portable device, a handheld device as a single unit and/or in electronic products or electric field that require various displays.

A display device may include a back plate and a plurality of display modules assembled in a grid array at a front surface of the back plate. The display device may be utilized as a monitor for a personal computer (PC), a high-resolution TV and signage (or, digital signage), an electronic display, and the like.

Embodiments of the disclosure will be described in detail below with reference to the accompanying drawings to aid in the understanding of those of ordinary skill in the art. However, the disclosure may be implemented in various different forms and it should be noted that the disclosure is not limited to the embodiments described herein. Further, in the drawings, parts not relevant to the description may be omitted, and like reference numerals may be used to indicate like elements throughout the whole of the disclosure. In the disclosure, the expression 'same' may mean not only fully matching, but also include a difference of an extent that considers a processing error range.

Although embodiments of the disclosure have been described in detail below with reference to the accompanied drawings and the descriptions of the accompanied drawings, however the disclosure is not limited thereto.

A display device according to an embodiment of the disclosure will be described below with reference to the drawings.

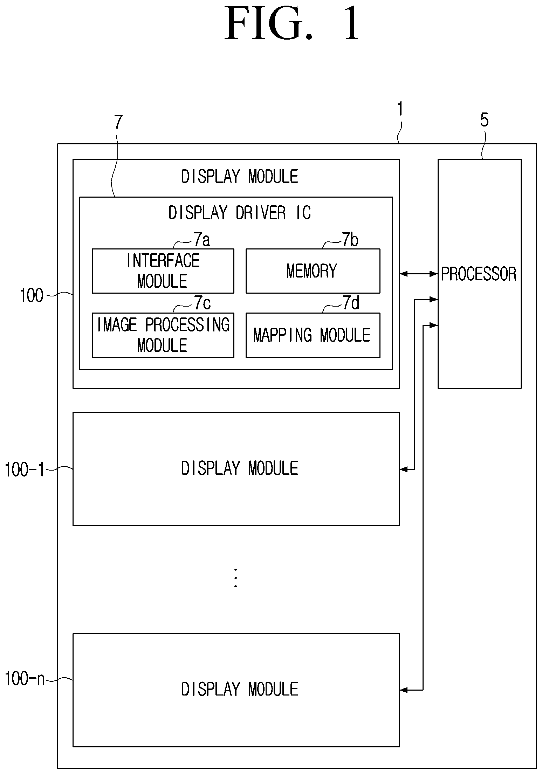

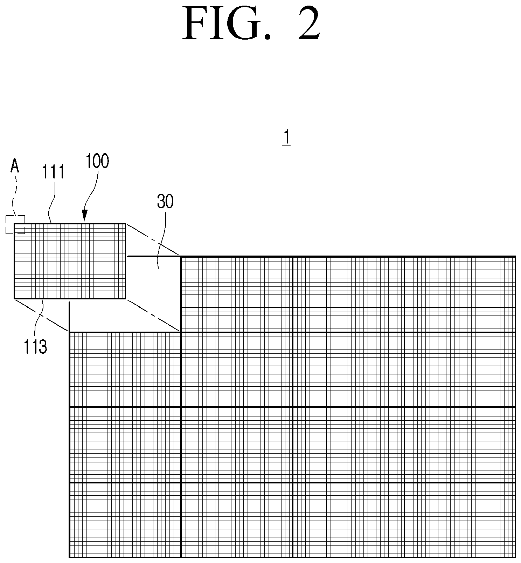

FIG. 1 is a block diagram of a display device according to an embodiment of the disclosure, and FIG. 2 is a diagram illustrating a display device grid arrayed with a plurality of display modules according to an embodiment of the disclosure.

Referring to FIG. 1, a display device 1 according to an embodiment of the disclosure may include a plurality of display modules 100, 100-1, ··· , and 100-n and a processor 5.

Referring to FIG. 2, a plurality of display modules 100 may be arranged at a back plate 30 in a grid array and form one screen. The plurality of display modules 100 may display various images. Here, an image may be a concept which includes a still image and/or a moving image. The plurality of display modules 100 may display various images such as, for example, and without limitation, broadcast content, multi-media content, and the like. In addition, the plurality of display modules 100 may also display a user interface (UI) and an icon.

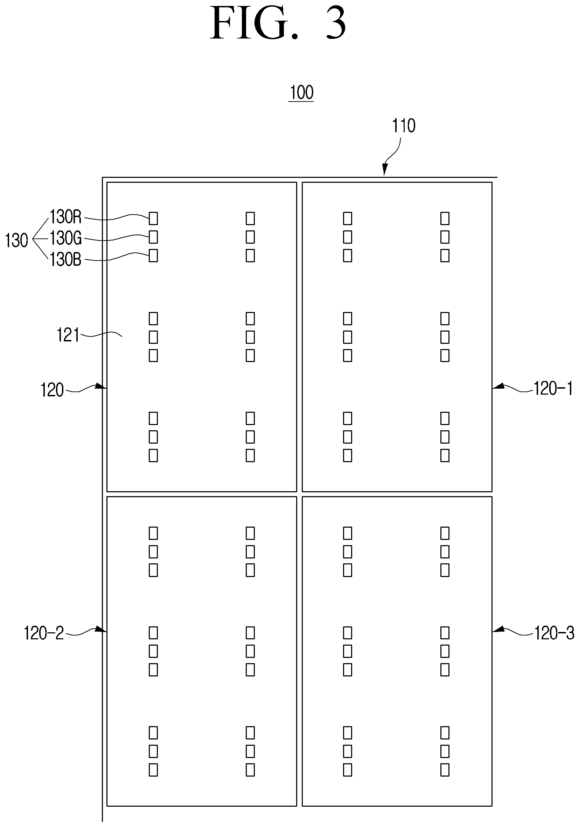

Each display module 100 may include a plurality of light emitting diode packages 120, 120-1, 120-2, and 120-3 (referring to FIG. 3), and a display driver IC (DDI) 7 for controlling the plurality of light emitting diode packages 120, 120-1, 120-2, and 120-3.

The display driver IC 7 may be mounted at a rear surface of a display substrate 110 (referring to FIG. 3).

The display driver IC 7 may include an interface module 7a, a memory 7b (e.g., a buffer memory), an image processing module 7c, and/or a mapping module 7d. The display driver IC 7 may receive, for example, image information including an image data or an image control signal corresponding to a command for controlling the image data from other elements of the display device 1 through the interface module 7a. For example, according to an embodiment, the image information may be received from the processor 5 (e.g., a main processor (e.g., an application processor)) or an auxiliary processor (e.g., a graphics processing device) operated independently from a function of the main processor.

The display driver IC 7 may store at least a portion from among the received image information in the memory 7b, for example, on a frame basis. The image processing module 7c may perform, for example, a pre-processing or a post-processing (e.g., resolution, brightness, or size adjustment) of at least a portion of the image data based on characteristics of the image data or characteristics of the display module 100. The mapping module 7d may generate a voltage value or a current value corresponding to the image data which is preprocessed or post-processed through the image processing module 7c. According to an embodiment, the generating of the voltage value or the current value may be performed, for example, based at least in part on characteristics of the pixels (e.g., array of pixels (an RGB stripe or a pentile structure), or sizes of the respective sub pixels) mounted to light emitting diode packages 120, 120-1, 120-2, and 120-3. Based on at least a portion of the pixels of the light emitting diode packages 120, 120-1, 120-2, and 120-3 being driven, for example, based at least in part on the voltage value of the current value, visual information (e.g., a text, an image, or an icon) corresponding to the image data may be displayed through the display module 100.

The display driver IC 7 included in the respective display modules may transmit a driving signal (e.g., a driver driving signal, a gate driving signal, etc.) to the corresponding display modules 100, 100-1, ···, and 100-n based on image information received from the processor 5.

The display driver IC 7 may display an image based on an image signal received from the processor 5. In an example, the display driver IC 7 may generate a driving signal of a plurality of sub pixels based on the image signal received from the processor 5, and display an image by controlling an emission of light of the plurality of sub pixels based on the driving signal.

The display module 100 may further include touch circuitry (not shown). The touch circuitry may include a touch sensor and a touch sensor IC for controlling the same. The touch sensor IC may control the touch sensor to detect, for example, a touch input or a hovering input of a designated position of the display module 100. For example, the touch sensor IC may detect the touch input or the hovering input by measuring a change in signal (e.g., voltage, amount of light, resistance, or electric charge) of the designated position of the display module 100. The touch sensor IC may provide information (e.g., position, area, pressure, or time) on the detected touch input or hovering input to the processor 5. According to an embodiment, at least a portion of the touch circuitry (e.g., touch sensor IC) may be included in the display driver IC 7, or as a part of the display module 100, or as a part of another element (e.g., auxiliary processor) arranged outside of the display module 100.

The processor 5 may be implemented as a digital signal processor (DSP) configured to process a digital image signal, a microprocessor, a graphics processing unit (GPU), an artificial intelligence (AI) processor, a neural processing unit (NPU), and a time controller (TCON). However, the embodiment is not limited thereto, and may include one or more from among a central processing unit (CPU), a micro controller unit (MCU), a micro processing unit (MPU), a controller, an application processor (AP), a communication processor (CP), or an ARM processor, or may be defined by the corresponding term. In addition, the processor 5 may be implemented as a System on Chip (SoC) or a large scale integration (LSI) embedded with a processing algorithm, and may be implemented in the form of an application specific integrated circuit (ASIC), or a field programmable gate array (FPGA).

The processor 5 may control hardware or software elements coupled to the processor 5 by driving an operating system or an application program, and perform various data processing and computations. In addition, the processor 5 may load and process commands or data received from at least one from among other elements in a volatile memory, and store various data in a non-volatile memory.

The display module 100 may be described in detail below with reference to FIG. 3 to FIG. 9.

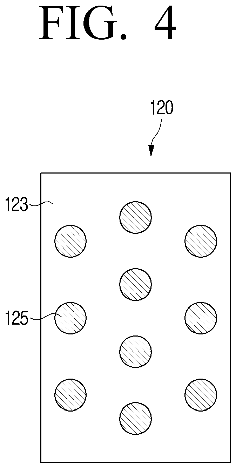

FIG. 3 is a diagram illustrating an enlarged A part of the display module shown in FIG. 2, and FIG. 4 is a diagram illustrating a rear surface of a light emitting diode package.

Referring to FIG. 3, the display module 100 may include the display substrate 110, and the plurality of light emitting diode packages 120, 120-1, 120-2, and 120-3 grid arrayed at a front surface of the display substrate 110.

Because the plurality of light emitting diode packages 120, 120-1, 120-2, and 120-3 have substantially the same structure, only one light emitting diode package 120 will be described.

The light emitting diode package 120 may be mounted with a package substrate 121, and pixels arrayed at a certain pixel pitch (or display pitch) at a front surface of the package substrate 121.

One pixel 130 may be formed of a plurality of sub pixels 130R, 130G, and 130B which emit light of wavelength bands of different colors from one another. For example, the one pixel 130 may include a first sub pixel 130R which emits light of a red wavelength band, a second sub pixel 130G which emits light of a green wavelength band, and a third sub pixel 130B which emits light of a blue wavelength band.

The plurality of sub pixels 130R, 130G, and 130B may be micro LEDs having a size of less than or equal to 100*µ*m as inorganic light emitting diodes. Each sub pixel may include a first semiconductor layer and a second semiconductor layer which are grown from an epi substrate, and an active layer arranged between the first semiconductor layer and the second semiconductor layer.

The first semiconductor layer may include, for example, a p-type semiconductor layer (an anode, an oxidation electrode). The p-type semiconductor layer may be selected from, for example, GaN, AIN, AlGaN, InGaN, InN, InAlGaN, AlInN, and the like, and a p-type dopant of Mg, Zn, Ca, Sr, Ba, and the like may be doped.

The second semiconductor layer may include, for example, an n-type semiconductor layer (a cathode, a reduction electrode). The n-type semiconductor layer may be selected from, for example, GaN, AIN, AlGaN, InGaN, InN, InAlGaN, AlInN, and the like, and an n-type dopant of Si, Ge, Sn, and the like may be doped.

The active layer may be an area in which electrons and holes are recombined, which transitions to a low energy level as electrons and holes recombine, and may generate light having an wavelength corresponding thereto.

The active layer may include a semiconductor material, for example, an amorphous silicon or a poly crystalline silicon. However the embodiment is not limited thereto and may contain an organic semiconductor material, and the like, and may be formed in a single quantum well (SQW) structure or a multi quantum well (MQW) structure.

The epi grown part of each sub pixel is not limited to the above-described configuration. For example, each sub pixel may be such that the first semiconductor layer includes the n-type semiconductor layer, and the second semiconductor layer includes the p-type semiconductor layer.

The package substrate 121 may be formed of multi-layers. At an inside of the package substrate 121, a micro IC of a digital driving method for controlling the driving of each sub pixel may be arranged. Accordingly, the display substrate 110 may be configured such that a plurality of TFTs for driving pixels is omitted. Meanwhile, if the micro IC is omitted in the package substrate 121, a plurality of TFT circuits may be provided in the display substrate 110.

The package substrate 121 may be provided with the micro IC, wiring which electrically couples each sub pixel, and a common electrode wiring.

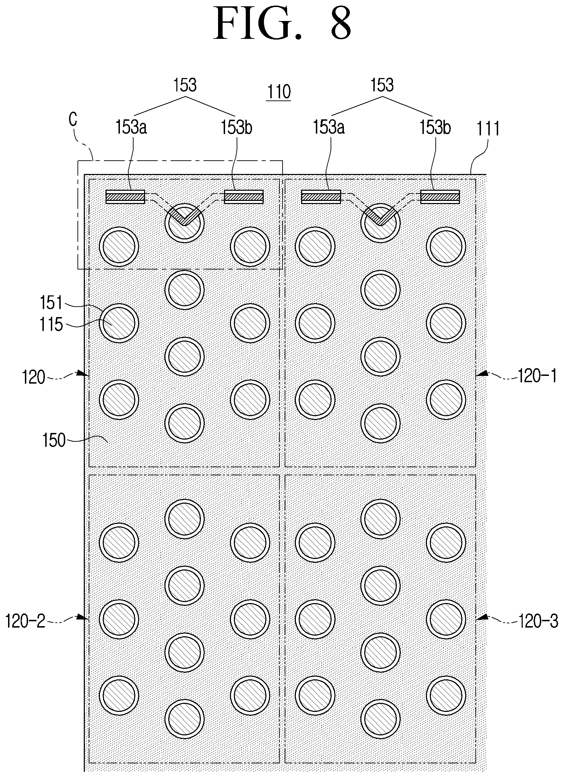

Referring to FIG. 4, at a rear surface of the package substrate 121, a plurality of first electrode pads 125 which are electrically coupled with the micro IC through wiring may be arranged. The plurality of first electrode pads 125 may be electrically connected to a plurality of second electrode pads 115 (referring to FIG. 8) arrayed at the front surface of the display substrate 110.

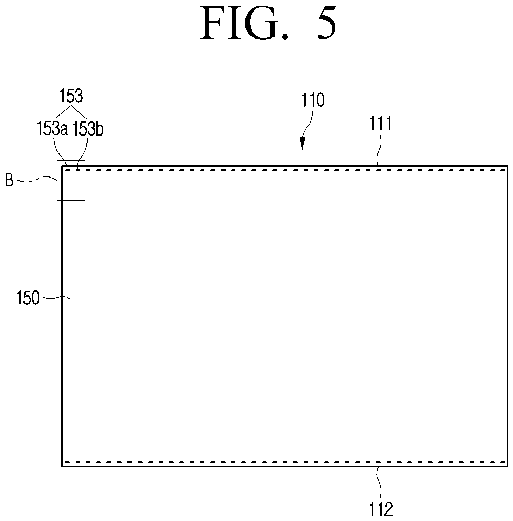

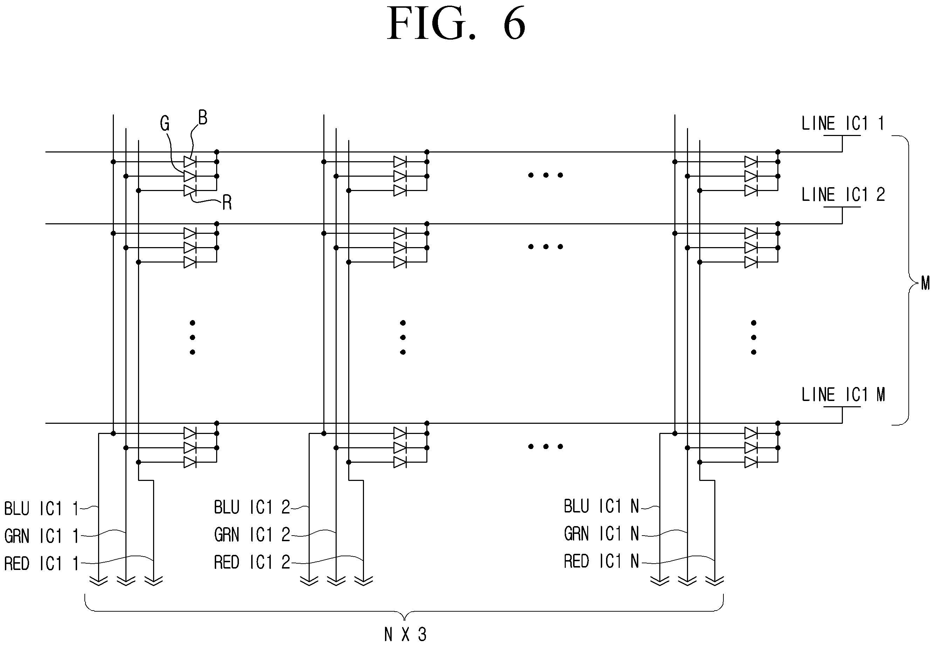

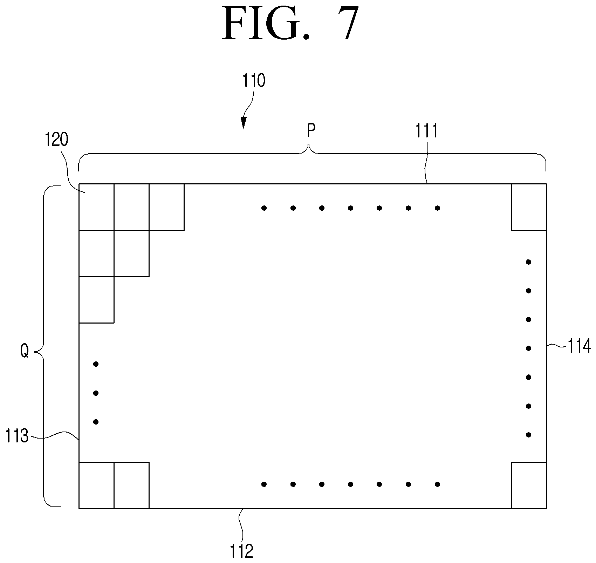

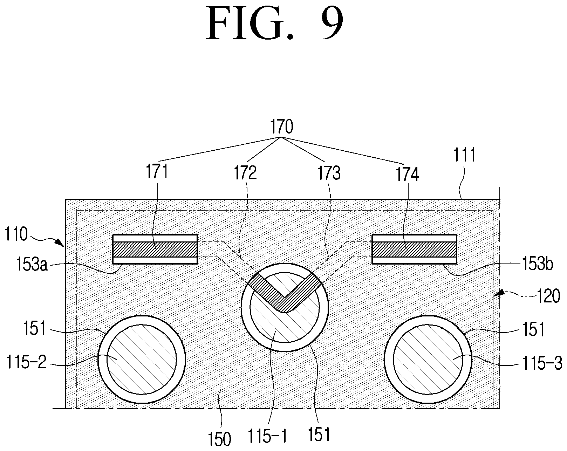

FIG. 5 is a diagram illustrating a pattern of ESD protection wiring provided at a front surface of a display substrate, FIG. 6 is a circuit diagram illustrating schematically a plurality of channel lines and a plurality of common scan lines coupled to pixels of a package substrate, FIG. 7 is a diagram grid arrayed with a plurality of light emitting diode packages on a display substrate, FIG. 8 is a diagram illustrating an enlarged B part of the display substrate shown in FIG. 5, and FIG. 9 is a diagram illustrating an enlarged C part of the display substrate shown in FIG. 8.

In FIG. 5, the plurality of second electrode pads 115 arrayed at the front surface of the display substrate 110 and ESD protection wiring 170 will be omitted from the drawing for convenience of description.

Referring to FIG. 5, the display substrate 110 may be stacked with an insulation layer 150 having a predetermined thickness at the front surface thereof. The insulation layer 150 may be formed of a non-conductive molding material (e.g., photo solder resist (PSR)).

The insulation layer 150 may block ESD from being introduced to the front surface of the display substrate 110. In this case, ESD may be introduced to a side end of the display module 110. That is, a fine gap may be formed between the front surface of the display substrate 110 and the insulation layer 150 due to the front surface of the display substrate 110 and the insulation layer 150 not being completely physically contacted. There may be a possibility of ESD being introduced inside the display module 100 through the gap.

The display substrate 110 may be provided with a plurality of ESD protection circuits (e.g., transient voltage suppressor (TVS) diode) for protecting a display pixel driving circuit (micro IC) from electrostatic discharge (ESD) which is introduced to an upper side, a lower side, a left side, and a right side of the display module 100.

The plurality of ESD protection circuits may be arranged in a bezel area adjacent to an upper side, a lower side, a left side, and a right side of the display substrate 110. In this case, because of a matrix driving method (a passive matrix (PM) and an active matrix (AM)) applied to the display substrate 110 and the arranging of the plurality of first electrode pads 125 of the light emitting diode package 120, a plurality of first TVS diodes may be densely arranged at the upper side and lower areas of the display substrate 110 and second TVS diodes of a smaller number than a number of first TVS diodes may be arranged in the left side and right side areas of the display substrate 110.

Referring to FIG. 6, a plurality of common scan lines may be arranged in a first direction (e.g., a horizontal direction of the package substrate) on the package substrate 121 of the light emitting diode package 120, and a plurality of channel lines may be arranged in a second direction which is orthogonal to the first direction. For example, the plurality of pixels mounted in one package substrate 121 may be grid arrayed into an N-number (N being a natural number of 2 or more) of columns and an M-number (M being a natural number of 2 or more) of rows. In this case, each pixel may be formed of three sub pixels. At this time, the plurality of channel lines may be an NX3-number, and the plurality of common scan lines may be an M-number. The NX3-number of channel lines may be respectively protected by the NX3-number of first TVS diodes, and the M-number of common scan lines may be protected by the M-number of second TVS diodes coupled respectively thereto.

The NX3-number of first TVS diodes and the M-number of second TVS diodes may be required corresponding to one light emitting diode package 120.

Referring to FIG. 7, if the plurality of light emitting diode packages 120 are grid arrayed into a P-number (P being a natural number of 2 or more) of columns and a Q-number (Q being a natural number of 2 or more) of rows on the display substrate 110, an (NX3) XP-number of first TVS diodes and an MXQ-number of second TVS diodes may be arranged on the display substrate 110. Accordingly, the number of first TVS diodes may be more than the number of second TVS diodes on the display substrate 110.

The plurality of first TVS diodes and a plurality of second TVS diodes may be arranged adjacently to outermost sides (an upper side 111, a lower side 112, a left side 113, and a right side 114 of the display substrate 110) of the display substrate 110. For example, the plurality of first TVS diodes may be arranged adjacently to the upper side 111 and the lower side 112 of the display substrate 110 along an arrangement direction of the plurality of channel lines, and the plurality of second TVS diodes may be arranged adjacently to the left side 113 and the right side 114 of the display substrate 110 along an arrangement direction of the plurality of common scan lines.

The ESD may not be introduced to the front surface of the display substrate 110 which is covered by the insulation layer 150. The ESD may be mainly introduced to the outermost sides of the display substrate 110 where fine gaps are formed between the display substrate 110 and the insulation layer 150 which covers the front surface of the display substrate 110.

The ESD being introduced to the outermost sides of the display substrate 110 may be absorbed into the plurality of first TVS diodes and the plurality of second TVS diodes arranged along the outermost sides of the display substrate 110, and a portion thereof may be absorbed into a plurality of ESD protection wiring 170 which is arranged along the upper side 111 and the lower side 112 of the display substrate 110. At this time, the respective ESD protection wiring 170 may be electrically coupled to a substrate electrode pad 115-1 (referring to FIG. 9) to which the first TVS diodes are coupled. The insulation layer 150 may be formed with a plurality of openings for wiring 153 along the upper side 111 and the lower side 112 of the display substrate 110. The plurality of openings for wiring 153 may be represented in a rough hidden line pattern.

The plurality of openings for wiring 153 may expose a portion of the ESD protection wiring 170 formed at the front surface of the display substrate 110. Accordingly, the upper side and the lower side of the display module 100 may be protected from ESD by the first TVS diodes and the ESD protection wiring 170 arranged along the upper side 111 and the lower side 112 of the display substrate 110.

Referring to FIG. 8, on the front surface of the display substrate 110, the plurality of second electrode pads 115 may be arranged at areas in which each of the light emitting diode packages 120, 120-1, 120-2, and 120-3 are mounted, respectively.

A plurality of openings for pads 151 may be formed at parts corresponding to the plurality of second electrode pads 115 for the plurality of second electrode pads 115 to be exposed on the insulation layer 150.

Referring to FIG. 9, the ESD protection wiring 170 may be formed at the front surface of the display substrate 110. The ESD protection wiring 170 may be a copper thin film having a predetermined length.

The ESD protection wiring 170 may be arranged between a plurality of second electrode pads 115-1, 115-2, and 115-3 and the upper side 111 of the display substrate which are arranged most closely to the upper side 111 of the display substrate 110 from among the plurality of second electrode pads 115.

In this case, the ESD protection wiring 170 may be arranged at a position which is covered by the light emitting diode package 120 when the light emitting diode package 120 is transferred to the display substrate 110. Accordingly, the ESD protection wiring 170 may not be visible because it is covered by the light emitting diode package 120 when a user views the front surface of the display module 100.

The ESD protection wiring 170 may be electrically coupled with one second electrode pad 115-1 from among the plurality of second electrode pads 115-1, 115-2, and 115-3.

The ESD protection wiring 170 may include a first part 171 and a fourth part 174 corresponding to both end parts, a second part 172 which is extended from the first part 171 and electrically coupled to the second electrode pad 115-1, and a third part 173 which is extended from the fourth part 174 and electrically coupled to the second electrode pad 115-1.

The first part 171 of the ESD protection wiring 170 may be arranged between the second electrode pad 115-2 and the upper side 111 of the display substrate 110. That is, the first part 171 of the ESD protection wiring 170 may be arranged more closely to the upper side of the display substrate 110 than the second electrode pad 115-2. Likewise, the fourth part 174 of the ESD protection wiring 170 may be arranged between the second electrode pad 115-3 and the upper side 111 of the display substrate 110. That is, the fourth part 174 of the ESD protection wiring 170 may be arranged more closely to the upper side 111 of the display substrate 110 than the second electrode pad 115-3.

In this case, the first part 171 of the ESD protection wiring 170 may be exposed by an opening for wiring 153a. In addition, the fourth part 174 of the ESD protection wiring 170 may be exposed by another opening for wiring 153b. Static electricity introduced to the upper side 111 of the display substrate 110 may be absorbed into the first part 171 and/or the fourth part 174 of the ESD protection wiring 170 exposed by the opening for wiring 153a. Accordingly, the light emitting diode package 120 may be protected from ESD by the first TVS diodes connected to the second electrode pad 115-1.

In the disclosure, because there is no need for separate first TVS diodes to be connected at the second electrode pads 115-2 and 115-3 which are arranged adjacently to each of the left side and the right side of the second electrode pad 115-1 by including the ESD protection wiring 170, the number of first TVS diodes that are arranged at an upper area of the display substrate 110 may be reduced. For the same reason as above, the number of second TVS diodes that are arranged at a lower area of the display substrate 110 may be reduced.

Accordingly, in the disclosure, mounting spaces of the first and second TVS diodes may be secured at the upper area and the lower area of the display substrate 110, manufacturing cost of the display substrate may be reduced, and processing time may be shortened.

The ESD protection wiring 170 may be provided in a number corresponding to the light emitting diode package 120 of two rows which are arrayed adjacently to each of the upper side 111 and the lower side 112 of the display substrate 110. In this case, the plurality of ESD protection wiring 170 may be arranged discontinuously along the upper side 111 and the lower side 112 of the display substrate 110.

Meanwhile, the display device 1 may be configured such that the above-described plurality of display modules 100 are grid arrayed at one surface of the back plate 30. In this case, the plurality of display modules 100 may be assembled to be separable from the back plate 30.

The display device 1 may be protected from ESD introduced between vertically adjacent display modules 100 by the ESD protection wiring 170 included in each display module 100. In addition, the display device 1 may be protected from ESD introduced between horizontally adjacent display modules 100 by the plurality of TSV diodes included in each display module 100.

In addition the ESD protection wiring 170 for protection again ESD may be covered by the plurality of light emitting diode packages 120. Accordingly, the ESD protection wiring 170 may not be visible to the user viewing an image through the display device 1.

While the disclosure has been shown and described with reference to the exemplary embodiments thereof, the disclosure is not limited to the embodiments specifically described and various modifications may be made therein by those skilled in the art to which this disclosure pertains without departing from the spirit and scope of the disclosure, and such modifications shall not be understood as separate from the technical concept or outlook of the present disclosure.

## Claims

1. A display module comprising:
a substrate comprising a plurality of first electrode pads at a front surface of the sub strate;
a plurality of light emitting diode packages comprising a plurality of second electrode pads on which a plurality of light emitting diodes are provided at a front surface of a plurality of light emitting diode packages and electrically connected to the plurality of first electrode pads at a rear surface of a plurality of light emitting diode packages; and
a first electrostatic discharge (ESD) protection wiring provided discontinuously along a first side of the substrate at the front surface of the substrate.

2. The display module of claim 1,
wherein the front surface of the substrate is covered with an insulation layer, and
wherein the insulation layer is provided with a plurality of first openings which expose the plurality of first electrode pads and a plurality of second openings which expose a portion of the first ESD protection wiring.

3. The display module of claim 2,
wherein the first ESD protection wiring comprises:
a center part configured to electrically connect to a first electrode pad among the plurality of first electrode pads, and
end parts adjacent to other first electrode pads which are spaced apart at both sides of the electrically connected first electrode pad, respectively.

4. The display module of claim 3,
wherein the first ESD protection wiring is configured such that the end parts are exposed by the plurality of second openings.

5. The display module of claim 1,
wherein the first ESD protection wiring is closer to the first side of the substrate than the plurality of first electrode pads.

6. The display module of claim 2,
wherein the plurality of second openings comprise a hidden line pattern.

7. The display module of claim 2, further comprising
a second ESD protection wiring provided discontinuously along a second side of the substrate, the second side being opposite of the first side of the substrate.

8. The display module of claim 7,
wherein the insulation layer further comprises a plurality of third openings which expose end parts of the second ESD protection wiring.

9. The display module of claim 1,
wherein the plurality of light emitting diode packages respectively comprise a micro integrated circuit (micro IC) chip configured to control a driving of the plurality of light emitting diodes.

10. A display module comprising:
a substrate;
a plurality of micro light emitting diode packages provided in a grid array at a first surface of the substrate; and
a first ESD protection wiring and a second ESD protection wiring which are respectively arranged discontinuously along two sides of the substrate at the first surface of the substrate.

11. The display module of claim 10,
wherein the first surface of the substrate is covered with an insulation layer, and
wherein the insulation layer comprises a plurality of openings which expose a portion of the first ESD protection wiring and a portion of the second ESD protection wiring.

12. The display module of claim 11,
wherein the plurality of openings comprise a hidden line pattern.

13. A display device comprising:
a first substrate;
a plurality of display modules provided in a grid array at the first substrate; and
a processor configured to control a driving of the plurality of display modules,
wherein the plurality of display modules respectively comprise:
a second substrate;
a plurality of micro light emitting diode packages provided in a grid array at a first surface of the second substrate;
a first ESD protection wiring and a first ESD protection wiring provided discontinuously along respective sides of the second substrate at the first surface of the second substrate; and
an insulation layer which covers the first surface of the second substrate and comprises a plurality of openings which expose a portion of the first ESD protection wiring and a portion of the second ESD protection wiring.

14. The display device of claim 13,
wherein the plurality of openings comprise a hidden line pattern.

15. The display device of claim 13,
wherein
a plurality of electrode pads to which the plurality of micro light emitting diode packages are electrically connected are provided at one surface of the second substrate,
wherein the first ESD protection wiring is provided between a first side of the second substrate and the plurality of electrode pads which are most adjacent to the one side of the substrate, and
wherein the second ESD protection wiring is provided between a second side of the second substrate opposite of the first side of the second substrate, and the plurality of electrode pads which are most adjacent to the opposite side of the substrate.
